Europäisches Patentamt

European Patent Office

Office européen des brevets

(19)

(11) **EP 1 480 499 A1**

(12) **EUROPEAN PATENT APPLICATION**
published in accordance with Art. 158(3) EPC

(43) Date of publication:
   **24.11.2004 Bulletin 2004/48**

(51) Int Cl.7: **H05H 1/24**, H01L 21/3065,
   C08J 7/00, B01J 19/08

(21) Application number: **03795290.0**

(22) Date of filing: **04.09.2003**

(86) International application number:
   **PCT/JP2003/011283**

(87) International publication number:
   **WO 2004/026008 (25.03.2004 Gazette 2004/13)**

(84) Designated Contracting States:
   **AT BE BG CH CY CZ DE DK EE ES FI FR GB GR
   HU IE IT LI LU MC NL PT RO SE SI SK TR**

(30) Priority: **13.09.2002 JP 2002267877**

(71) Applicants:
   • **Pearl Kogyo Co., Ltd**
     **Osaka-shi, Osaka 559-0015 (JP)**

   • **FUJISAWA PHARMACEUTICAL CO., LTD.**
     **Osaka-shi Osaka 541-8514 (JP)**

(72) Inventor: **SAEKI, Noboru Pearl Kogyo Co., Ltd.**
   **Osaka-shi, Osaka 559-0015 (JP)**

(74) Representative: **Fleuchaus, Leo, Dipl.-Ing. et al
   Fleuchaus & Gallo,
   Melchiorstrasse 42
   81479 München (DE)**

(54) **PLASMA SURFACE TREATING METHOD AND APPARATUS THEREFOR**

(57) Without requiring ejection of air or the like, the amount and area of irradiation of excited species to a workpiece surface can be increased, the whole surface can be uniformly irradiated, and the loss of effective excited species can be suppressed, whereby the treatment performance and the treatment efficiency can be remarkably improved. In a method in which a pulse voltage is applied to a pair of opposing discharge electrodes 1, 1 to produce corona discharge between pointed ends 1a, 1a, and excited species including plasma are produced by the corona discharge, thereby conducting a surface treatment, a magnetic field is formed in the vicinity of the pointed ends 1a, 1a of the discharge electrodes 1, 1, by magnetic field forming means configured by a permanent magnet 4, magnetic members 5, and pole pieces 6, and the excited species are irradiated toward the surface Wf of a workpiece W by a Lorentz force which acts as a pushing force on charged particles moving in the magnetic field, thereby conducting a surface treatment.

Fig. 2

EP 1 480 499 A1

## Description

Technical Field

The present invention is applied mainly to various surface treatments such as those of, in the case where application of a coating composition or a printing process is conducted on a resin such as polyethylene, polypropylene, or PTFE (polytetrafluoroethylene), modifying the water-repellent property of the surface to the water-attracting property, washing away organics adhering to the surface of glass, ceramics, a metal, or a semiconductor, conducting disinfection or sterilization, and performing an etching process. More particularly, the invention relates to a plasma surface treating method of the corona discharge type in which a surface treatment such as modification is conducted by irradiating the surface of a workpiece with excited species such as excited molecules, radicals, or ions which are generated as a result of molecular dissociation due to plasma produced by corona discharge, and also to an apparatus therefor.

Conventional Art

A plasma surface treating method of the corona discharge type has an advantage that the use of an ignition gas such as helium, argon, or hydrogen which is required in the case of a plasma surface treating method of the glow discharge type can be omitted, and improvement of the safety in use and reduction of the treatment cost due to a reduced gas consumption can be realized. Therefore, the method is often used in surface treatments such as surface modification.

In such a plasma surface treating method of the corona discharge type, important factors in determining the treatment performance and the treatment efficiency are the amount, area, and uniformity of irradiation of excited species including plasma produced by corona discharge, to the surface of a workpiece. As means for attaining these important factors, conventionally, a method is employed in which, for example, a tip end portion of a discharge electrode is formed into a hollow pin-like shape, an air nozzle is disposed in the tip end, or a hollow insulation holder is disposed in the outer periphery of the discharge electrode, and an air ejection hole is disposed in plural places surrounding the discharge electrode in the tip end face of the insulation holder, and excited species including plasma are irradiated toward the surface of the workpiece by ejection of high-pressure high-speed air from the nozzle or the ejection holes (for example, see Japanese Patent Application Laying-Open No. 8-81573).

In the conventional plasma surface treating method of the corona discharge type in which a gas such as high-pressure high-speed air is ejected in order to conduct irradiation by excited species as described above, however, the discharge electrode or the insulation holder must be finely worked so as to conduct the ejection of gas such as air, and moreover high-pressure supply equipment for air or another gas, such as a compressor or a blower is required. Therefore, the whole apparatus tends to be increased in size and cost. Although the amount and area of irradiation of excited species can be controlled by adjusting the pressure and angle of the gas ejection, the adjustment range is inevitably restricted. Particularly, it is difficult to averagely uniformly irradiate the whole workpiece surface with excited species, in both technical and structural viewpoints. Since a gas such as air which does not participate in the surface treatment itself is ejected together with excited species to the surface of a workpiece, moreover, the amount of effective excited species is small with respect to the total irradiation amount, and excited species are largely lost due to splash and peripheral escape of the gas such as air, thereby causing a problem in that improvements of the predetermined surface treatment performance and the treatment efficiency are limited.

The invention has been conducted in view of the above-mentioned circumstances. It is an object of the invention to provide a plasma surface treating method and also an apparatus therefor in which, without requiring ejection of a gas such as air, the amount and area of irradiation of excited species to a workpiece surface can be increased, the whole surface can be uniformly irradiated, and the loss of effective excited species can be suppressed, whereby the treatment performance and the treatment efficiency can be remarkably improved.

Disclosure of the Invention

In order to attain the object, a plasma surface treating method of claim 1 of the invention is a plasma surface treating method in which a pulse voltage is applied to a pair of opposing discharge electrodes to produce corona discharge between pointed ends of the discharge electrodes, and a surface of a workpiece is irradiated with excited species including plasma produced by the corona discharge, thereby treating the surface, wherein

a magnetic field is formed in a vicinity of the pointed ends of the pair of discharge electrodes where charged particles in the plasma exist, and the excited species including plasma are irradiated toward the surface of the workpiece by a force which acts as a pushing force on charged particles moving in the magnetic field.

A plasma surface treating apparatus of claim 5 of the invention is a plasma surface treating apparatus in which a pulse voltage is applied to a pair of opposing discharge electrodes to produce corona discharge between pointed ends of the discharge electrodes, and a surface of a workpiece is irradiated with excited species including plasma produced by the corona discharge, thereby treating the surface, wherein

magnetic field forming means is disposed which forms a magnetic field in a vicinity of the pointed ends of the pair of discharge electrodes where charged particles in the plasma exist, and which can apply a pushing force on charged particles moving in the magnetic field, the pushing force causing the excited species including plasma to be irradiated toward the surface of the workpiece.

According to the thus configured invention, when, in the state where a magnetic field is formed in the vicinity of the pointed ends of the pair of discharge electrodes, a pulse voltage is applied to the pair of discharge electrodes to produce corona discharge between the pointed ends of the electrodes, excited species including plasma produced by the corona discharge exist in the magnetic field, and the magnetic field applies a pushing force, i.e., a Lorentz force on charged particles in the plasma moving in the magnetic field. Because of the Lorentz force, a force which is perpendicular to the magnetic field is applied to the excited species including plasma. Even when a gas such as high-pressure high-speed air is not ejected, therefore, excited species can be vigorously irradiated toward the workpiece surface in a substantially uniform manner over a wide area. Since a gas such as air which does not directly participate in the surface treatment itself is not used, only excited species which are effective components of the surface treatment are irradiated, so that the loss of excited species due to splash of the gas or the like can be suppressed. Therefore, the surface treatment performance and the treatment efficiency can be remarkably improved.

In the plasma surface treating method and apparatus of the corona discharge type, as the pulse voltage to be applied to the discharge electrodes, either of a rectangular pulse voltage as set forth in claims 2 and 6, or a pulse voltage formed by plural pulsating waves obtained by half-wave rectifying or full-wave rectifying an alternating voltage as set forth in claims 3 and 7 may be used. In the case where a pulse voltage formed by pulsating waves is used, particularly, a special pulse voltage generating power source is not required, and a pulse voltage of a desired period and duty can be applied by using a simple power source device configured by a combination of an AC power source of the commercial or ultrasonic range and rectifying elements such as diodes. Therefore, reduction of the cost of the apparatus can be realized.

The magnetic field forming means in the plasma surface treating apparatus of the corona discharge type may be either of means configured by a permanent magnet, a pair of magnetic members, and a pair of pole pieces which form a gap between end faces as set forth in claim 8, or that configured by an electromagnet connected to a DC power source, a pair of magnetic members, and a pair of pole pieces which form a gap between end faces as set forth in claim 9. In the case where a permanent magnet is used, the production cost and the power consumption can be reduced. By contrast, in the case where an electromagnet is used, the production cost and the power consumption are increased as compared with the case where a permanent magnet is used, but a Lorentz force, and therefore the irradiation power and irradiation diffusion range of excited species including plasma can be controlled easily and arbitrarily in accordance with the surface morphology of the workpiece and the like, by adjusting the magnetic flux density in the gap between the end faces of the pole pieces. Therefore, the shape adaptability to the workpiece can be expanded, and the treatment performance and the treatment efficiency can be further improved.

In the invention, it is not required to use a reactive gas such as argon gas, nitrogen gas, or carbon dioxide gas. Alternatively, as set forth in claims 4 and 10, such a reactive gas may be introduced between the pair of discharge electrodes at atmospheric pressure or the vicinity of atmospheric pressure, whereby an excitation gas flow including plasma is caused to be irradiated by a pushing force (Lorentz force) received from the magnetic field, thereby enabling the method and the apparatus to be used in various surface treatments.

Brief Description of the Drawings

Fig. 1 is a partially omitted longitudinal front section view showing a first embodiment of the plasma surface treating apparatus of the invention.
Fig. 2 is a longitudinal side section view taken along the line A-A in Fig. 1.
Fig. 3 is a diagram of a half-wave rectifying circuit which is an example of a power source device in the treating apparatus.
Fig. 4 is a waveform chart of a pulsating voltage which is rectified by the half-wave rectifying circuit.
Fig. 5 is a diagram of a full-wave rectifying circuit which is another example of the power source device in the treating apparatus.
Fig. 6 is a waveform chart of a pulsating voltage which is rectified by the full-wave rectifying circuit.
Fig. 7 is a partially omitted longitudinal front section view showing a second embodiment of the plasma surface treating apparatus of the invention.
Fig. 8 is a longitudinal side section view taken along the line B-B in Fig. 7.

Best Mode for Carrying Out the Invention

Hereinafter, embodiments of the invention will be described with reference to the drawings.

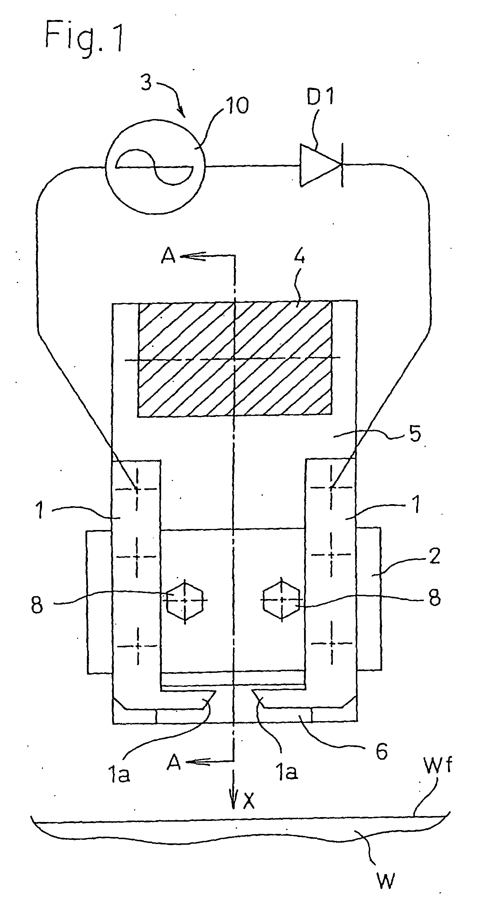

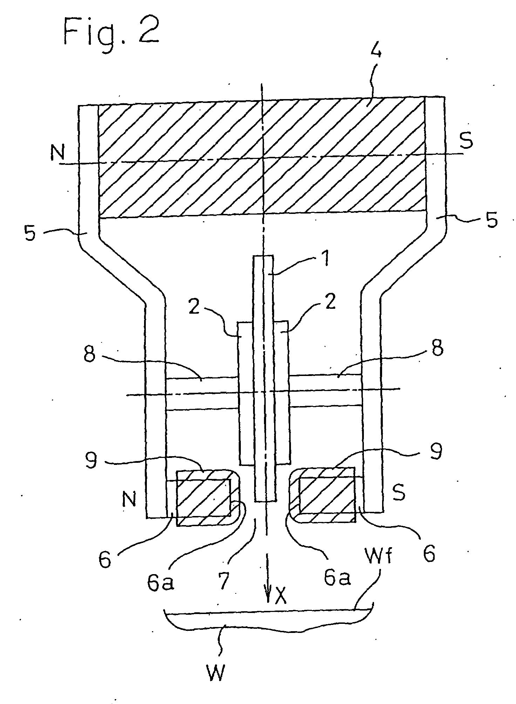

Fig. 1 is a partially omitted longitudinal front section view showing a first embodiment of the plasma surface treating apparatus of the invention, and Fig. 2 is a longitudinal side section view taken along the line A-A in Fig. 1. The plasma surface treating apparatus of the first embodiment is configured in the following manner. A pair of (+) and (-) discharge electrodes 1, 1 which are produced from a metal material such as stainless steel into an approximately L-like shape are clampingly fixed between electrode holders 2, 2 made of an insulator, in a state where their pointed tip end portions or pointed ends 1a, 1a are opposed to each other. A power source device 3 (described later) which, as a pulse voltage, applies a pulse voltage formed by plural pulsating waves obtained by half-wave rectifying or full-wave rectifying an alternating voltage is connected to the pair of discharge electrodes 1, 1. When the pulse voltage is applied from the power source device 3 to the pair of discharge electrodes 1, 1, corona discharge is produced between the pointed ends 1a, 1a of the electrodes 1, 1. Excited species including plasma are produced by the corona discharge.

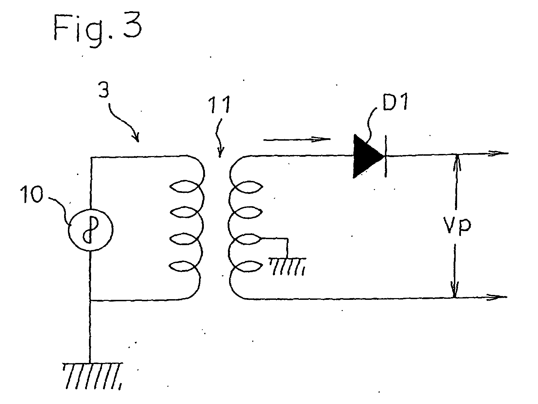

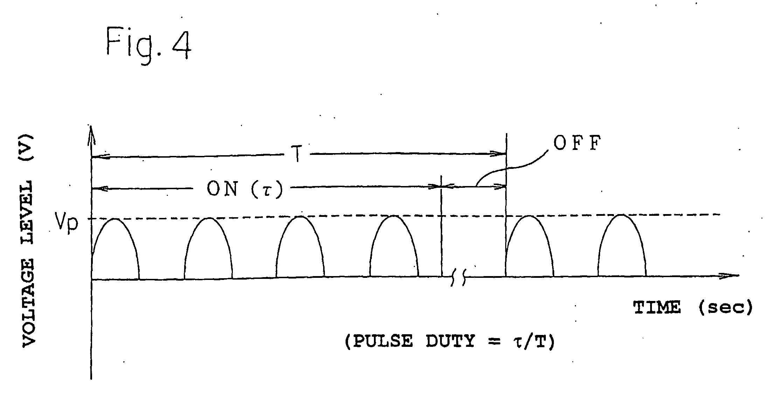

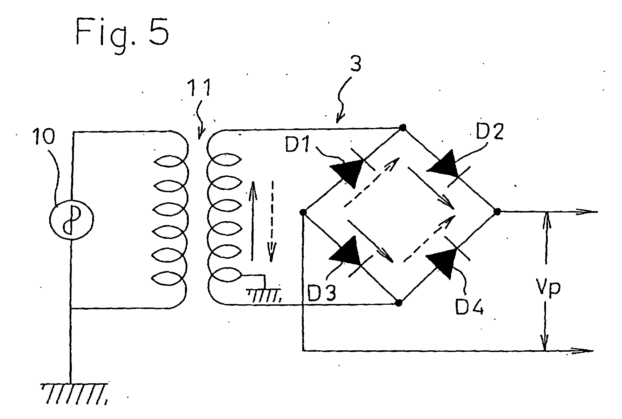

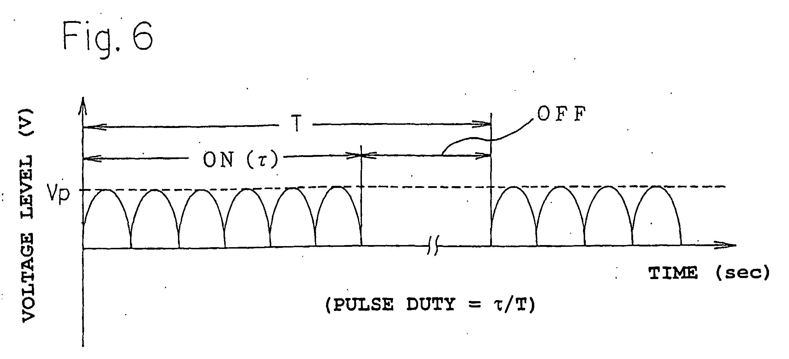

As the power source device 3, either of devices configured in the following manners is used. As clearly shown in Fig. 3, for example, only a positive voltage of an alternating current is taken out by a half-wave rectifying circuit using: an AC power source 10 of 50 Hz to 100 KHz; a step-up transformer 11; and one rectifying diode D1, so that, as shown in Fig. 4, the alternating current is converted to DC pulsating waves having a peak value Vp of 5 to 15 KV, and a positive pulse voltage in which, when the sum of the ON times and the OFF times of the plural converted pulsating waves is set as one period T, the pulse frequency (1/T) is 10 to 200 Hz and the pulse duty is 10 to 100% is generated. Alternatively, as shown in Fig. 5, not only a positive voltage of an alternating current, but also a negative voltage which is inverted to the direction of the positive voltage and then added is taken out by a bridge full-wave rectifying circuit using as shown in Fig. 5: an AC power source 10 of 50 Hz to 100 KHz; a step-up transformer 11; and four rectifying diodes D1 to D4, so that, as shown in Fig. 6, the alternating current is converted to DC pulsating waves having a peak value of 5 to 15 KV, and a positive pulse voltage in which, when the sum of the ON times and the OFF times of the plural converted pulsating waves is set as one period T, the pulse frequency is 10 to 200 Hz and the pulse duty is 10 to 100% is generated. Although a positive pulse voltage is used in the above, it is a matter of course that a negative pulse voltage can be used.

Magnetic field forming means for forming a magnetic field along a horizontal plane where charged particles in plasma produced by coronal discharge exist is disposed in a position nearest to the pointed ends 1a, 1a of the pair of discharge electrodes 1, 1. The magnetic field forming means is configured by: a permanent magnet 4 which is placed above basal end portions of the discharge electrodes 1, 1; a pair of soft magnetic members 5, 5 which are made of pure iron or the like, which are connected to the N and S poles of the permanent magnet 4, and which elongate to the vicinities of the pointed ends 1a, 1a of the pair of discharge electrodes 1, 1; and a pair of pole pieces 6, 6 which are made of pure iron or the like, which are continuously integrated with tip ends of the soft magnetic members 5, 5, and which form a magnetic field forming gap 7 between end faces 6a, 6a that are opposed to each other across the pointed ends 1a, 1a of the pair of discharge electrodes 1, 1. In accordance with movement of charged particles of plasma in the magnetic field which is formed in the gap 7 between the end faces 6a, 6a of the pole pieces 6, 6 in the magnetic field forming means, a pushing force, i.e., a Lorentz force acts on the charged particles, and excited species including plasma are irradiated toward the surface Wf of a workpiece W as indicated by the arrow X in Figs. 1 and 2.

When the charge of a particle is Q, the velocity is v, and the magnetic flux density in the gap between the end faces of the pole pieces is B, the Lorentz force F is expressed by:

$$F = Qv \times B.$$

The Lorentz force acts perpendicularly on the velocity vector of charged particles, so that excited species including plasma are pushed and irradiated in the direction of the arrow X.

The pair of soft magnetic members 5, 5, and the electrode holders 2, 2 are fixed and coupled to each other via insulation spacers 8, 8, whereby the magnetic field forming means and the pair of discharge electrodes 1, 1 are integrated with each other. Insulative protection covers 9, 9 such as ceramics are fitted onto the pole pieces 6, 6.

In the thus configured plasma surface treating apparatus of the corona discharge type of the first embodiment, a magnetic field configured by an effective magnetic flux and a leakage magnetic flux is formed in the gap 7 between the end faces 6a, 6a of the pole pieces 6, 6 which are connected to the N and S poles of the permanent magnet 4 via the soft magnetic members 5, 5. In this state, the power source device 3 using the above-mentioned half-wave rectifying circuit or full-wave rectifying circuit applies a positive or negative pulse voltage of a frequency of 10 to 200 Hz to the pair of discharge electrodes 1, 1, to produce corona discharge between the pointed ends 1a, 1a of the electrodes 1, 1. As a result, excited species including plasma produced by the corona discharge exist in the magnetic field. A force in the direction of the arrow X which is perpendicular to the magnetic field is applied to the excited species including plasma by the above-mentioned Lorentz force F that is received from the magnetic field by charged particles in the plasma moving in the magnetic field. As a result, even when a gas such as high-pressure high-speed air is not ejected, excited species including plasma can be vigorously irradiated toward the surface Wf of the workpiece W in a substantially uniform manner over a wide area.

Moreover, it is not required to use a gas such as air which does not directly participate in the surface treatment itself, and only excited species which are effective components of the surface treatment are irradiated to the surface Wf of the workpiece W. Therefore, the loss such as peripheral escape of the excited species due to, for example, splash of the ejection gas such as high-pressure high-speed air can be suppressed, and the predetermined surface treatment performance and the treatment efficiency can be remarkably improved. When the pole pieces 6, 6 are replaced with those of various shapes, the ejection pattern of excited species can be freely changed, and the embodiment can be effectively used also in a two-dimensional or three-dimensional surface treatment.

In the first embodiment, a positive or negative pulse voltage formed by plural pulsating waves obtained by half-wave rectifying or full-wave rectifying an alternating voltage is used in the pair of discharge electrodes 1, 1. Therefore, a special pulse voltage generating power source such as a multivibrator, a Schmidt trigger circuit, or a blocking oscillator is not required, and a pulse voltage of a desired period and duty can be applied by using a simple power source device configured by a combination of a commercial AC power source or an ultrasonic power source and rectifying elements such as diodes. Moreover, the permanent magnet 4 which can be produced at a low cost, and which does not consume an electric power is used as the magnetic field forming means. As a result, the introduction cost and running cost of the whole apparatus can be reduced.

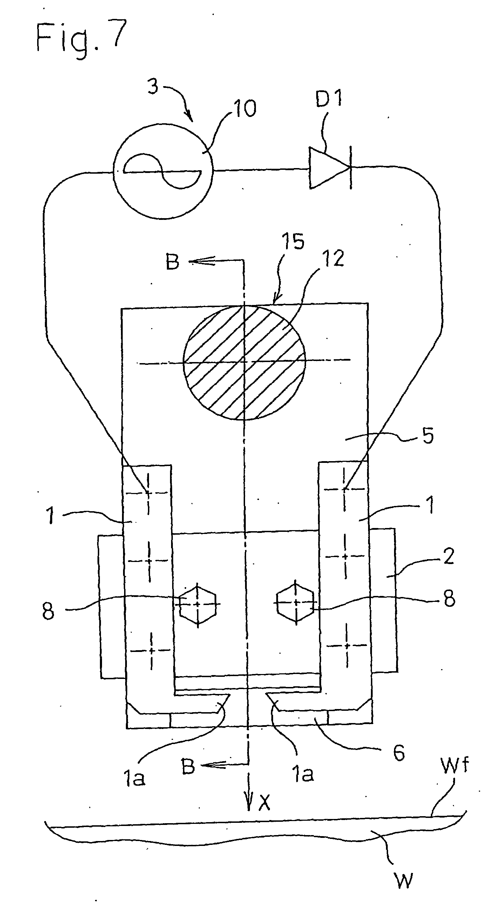

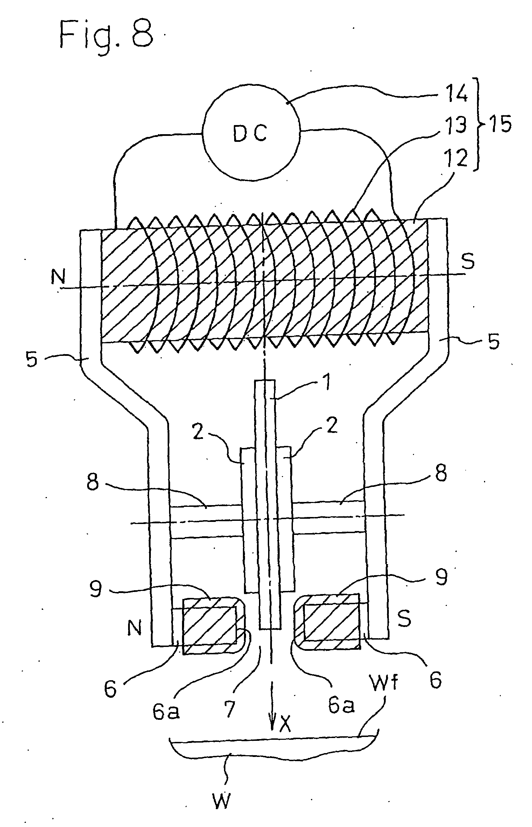

Fig. 7 is a partially omitted longitudinal front section view showing a second embodiment of the plasma surface treating apparatus of the invention, and Fig. 8 is a longitudinal side section view taken along the line B-B in Fig. 7. In the plasma surface treating apparatus of the second embodiment, in place of the permanent magnet 4 in the first embodiment constituting the magnetic field forming means, an electromagnet 15 is used in which, for example, a coil 13 is wound around a core 12 made of pure iron or the like, and the coil 13 is connected to a DC power source 14. The other configuration is identical with that of the first embodiment. Therefore, corresponding members and portions are denoted by the same reference numerals, and their detailed description is omitted.

Also in the plasma surface treating apparatus of the second embodiment, in the same manner as the first embodiment, charged particles in plasma produced due to corona discharge exist in the magnetic field, and a force in the direction of the arrow X which is perpendicular to the magnetic field is applied to the excited species including plasma by the Lorentz force F received from the magnetic field. As a result, even when a gas such as high-pressure high-speed air is not ejected, excited species including plasma can be vigorously irradiated toward the surface Wf of the workpiece W in a substantially uniform manner over a wide area. Moreover, only excited species which are effective components of the surface treatment are irradiated to the surface Wf of the workpiece W, and the loss such as peripheral escape of the excited species due to, for example, splash of the ejection gas such as high-pressure high-speed air can be suppressed, so that the predetermined surface treatment performance and the treatment efficiency can be remarkably improved. Furthermore, the magnetic flux density in the gap 7 between the end faces of the pole pieces 6, 6 can be controlled in a wide range by adjusting the energization current supplied to the coil 13. According to the configuration, the Lorentz force F, and therefore the irradiation power and irradiation diffusion range of the excited species including plasma can be controlled easily and arbitrarily in accordance with the surface morphology of the workpiece W and the like, the shape adaptability to the workpiece W can be expanded, and the treatment performance and the treatment efficiency can be further improved.

In the above, the first and second embodiments in which a reactive gas such as argon gas, nitrogen gas, or carbon dioxide gas is not used have been described. Alternatively, such a reactive gas may be introduced between the pair of discharge electrodes at atmospheric pressure or the vicinity of atmospheric pressure, and an excitation gas flow including plasma may be caused to be irradiated toward the surface of a workpiece by a Lorentz force received from the magnetic field. In the alternative, the adaptability to a surface treatment can be expanded.

As described above, according to the invention, excited species including plasma produced by corona discharge can be irradiated toward the workpiece surface by a Lorentz force acting on charged particles in the plasma. Therefore, the use of a gas such as high-pressure high-speed air which is conventionally used for irradiation of excited species can be omitted, and it is not required to finely work the discharge electrodes and the insulation holders, and also to install high-pressure supply equipment for a gas, such as a compressor or a blower, so that miniaturization and cost reduction of the whole apparatus can be realized. Moreover, the amount and area of irradiation of excited species to the workpiece surface can be easily increased, the excited species can be uniformly irradiated to the whole workpiece surface, and the loss of the effective excited species due to peripheral splash and the like can be suppressed. Therefore, the invention attains an effect that the surface treatment performance and the treatment efficiency can be remarkably improved.

Particularly, a pulse voltage formed by plural pulsating waves obtained by half-wave rectifying or full-wave rectifying an alternating voltage is used as the pulse voltage to be applied to the discharge electrodes. Even when a special pulse voltage generating power source is not used, therefore, a pulse voltage of a desired period and duty can be applied by using a simple power source device configured by a combination of an AC power source of the commercial or ultrasonic range and rectifying elements such as diodes. Consequently, further reduction of the cost of the apparatus can be realized.

When means configured by an electromagnet connected to a DC power source, a pair of magnetic members, and a pair of pole pieces is used as the magnetic field forming means, the Lorentz force can be controlled by adjusting the magnetic flux density in the gap between the end faces of the pole pieces, and the irradiation power and irradiation diffusion range of excited species including plasma can be controlled easily and arbitrarily in accordance with the surface morphology of the workpiece and the like. Therefore, the shape adaptability to the workpiece can be expanded, and the treatment performance and the treatment efficiency can be further improved.

**Claims**

1.  A plasma surface treating method in which a pulse voltage is applied to a pair of opposing discharge electrodes to produce corona discharge between pointed ends of said discharge electrodes, and a surface of a workpiece is irradiated with excited species including plasma produced by the corona discharge, thereby treating said surface, wherein

    a magnetic field is formed in a vicinity of said pointed ends of said pair of discharge electrodes where charged particles in the plasma exist, and the excited species including plasma are irradiated toward said surface of said workpiece by a force which acts as a pushing force on charged particles moving in the magnetic field.

2.  A plasma surface treating method according to claim 1, wherein a rectangular pulse voltage is used as the pulse voltage.

3.  A plasma surface treating method according to claim 1, wherein a pulse voltage formed by plural pulsating waves obtained by half-wave rectifying or full-wave rectifying an alternating voltage is used as the pulse voltage.

4.  A plasma surface treating method according to any one of claims 1 to 3, wherein a reactive gas is introduced between said pair of discharge electrodes at atmospheric pressure or a vicinity of atmospheric pressure, whereby an excitation gas flow including plasma is caused to be irradiated toward said surface of said workpiece by a pushing force received from the magnetic field.

5.  A plasma surface treating apparatus in which a pulse voltage is applied to a pair of opposing discharge electrodes to produce corona discharge between pointed ends of said discharge electrodes, and a surface of a workpiece is irradiated with excited species including plasma produced by the corona discharge, thereby treating said surface, wherein

    magnetic field forming means is disposed which forms a magnetic field in a vicinity of said pointed ends of said pair of discharge electrodes where charged particles in the plasma exist, and which can apply a pushing force on charged particles moving in the magnetic field, the pushing force causing the excited species including plasma to be irradiated toward said surface of said workpiece.

6.  A plasma surface treating apparatus according to claim 5, wherein said pulse voltage applying means is a rectangular pulse voltage generating power source.

7.  A plasma surface treating apparatus according to claim 5, wherein said pulse voltage applying means is configured by an AC power source, and a rectifying circuit which generates a pulse voltage formed by plural pulsating waves obtained by half-wave rectifying or full-wave rectifying an alternating voltage of said power source.

8.  A plasma surface treating apparatus according to any one of claims 5 to 7, wherein said magnetic field forming means is configured by: a permanent magnet; a pair of magnetic members which are connected to N and S poles of said permanent magnet, and which elongate to vicinities of said pointed ends of said pair of discharge electrodes; and a pair of pole pieces which are continuous to tip ends of said magnetic members, and which form a gap between end faces.

9.  A plasma surface treating apparatus according to any one of claims 5 to 7, wherein said magnetic field forming means is configured by: an electromagnet connected to a DC power source; a pair of magnetic members which are connected to N and S poles of said electromagnet, and which elongate to vicinities of said pointed ends of said pair of discharge electrodes; and a pair of pole pieces which are continuous to tip ends of said magnetic members, and which form a gap between end faces.

10. A plasma surface treating apparatus according to any one of claims 5 to 9, wherein means for introducing a reactive gas between said pair of discharge electrodes at atmospheric pressure or a vicinity of atmospheric pressure is disposed, and the reactive gas is introduced via said means, whereby an excitation gas flow including plasma is caused to be irradiated toward said surface of said workpiece by a pushing force received from the magnetic field.

Fig. 1

Fig. 2

Fig. 3

Fig. 4

# Fig. 5

## Fig. 6

Fig.7

Fig. 8

## INTERNATIONAL SEARCH REPORT

| International application No. |
|---|
| PCT/JP03/11283 |

A. CLASSIFICATION OF SUBJECT MATTER
   Int.Cl$^7$  H05H1/24, H01L21/3065, C08J7/00, B01J19/08

According to International Patent Classification (IPC) or to both national classification and IPC

B. FIELDS SEARCHED

Minimum documentation searched (classification system followed by classification symbols)
   Int.Cl$^7$  H05H1/24, H01L21/3065, C08J7/00, B01J19/08

Documentation searched other than minimum documentation to the extent that such documents are included in the fields searched
   Jitsuyo Shinan Koho          1926–1996   Toroku Jitsuyo Shinan Koho   1994–2003
   Kokai Jitsuyo Shinan Koho    1971–2003   Jitsuyo Shinan Toroku Koho   1996–2003

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 7-211657 A  (Semiconductor Energy Laboratory Co., Ltd.), 11 August, 1995 (11.08.95), Par. Nos. [0019], [0023], [0028] to [0033]; Figs. 1 to 2 (Family: none) | 1-10 |
| Y | JP 7-118419 A  (Olympus Optical Co., Ltd.), 09 May, 1995 (09.05.95), Par. Nos. [0009], [0025] to [0027]; Fig. 4 (Family: none) | 1-10 |
| Y | JP 2002-115174 A  (Takuzo IWATA), 19 April, 2002 (19.04.02), Par. Nos. [0017] to [0020]; Figs. 1 to 3 (Family: none) | 1-10 |

☒ Further documents are listed in the continuation of Box C.  ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 04 December, 2003 (04.12.03) | 16 December, 2003 (16.12.03) |

| Name and mailing address of the ISA/ | Authorized officer |
|---|---|
| Japanese Patent Office | |
| Facsimile No. | Telephone No. |

Form PCT/ISA/210 (second sheet) (July 1998)

## INTERNATIONAL SEARCH REPORT

| International application No. |
| --- |
| PCT/JP03/11283 |

C (Continuation).  DOCUMENTS CONSIDERED TO BE RELEVANT

| Category* | Citation of document, with indication, where appropriate, of the relevant passages | Relevant to claim No. |
| --- | --- | --- |
| Y | JP 8-500699 A  (Societe Europeenne de Propulsion), 23 January, 1996 (23.01.96), Page 14, line 10 to page 20, line 1; Figs. 1 to 6 & WO 95/00758 A1 | 8-9 |
| A | JP 10-270428 A  (Mitsubishi Electric Corp.), 09 October, 1998 (09.10.98), Full text; all drawings (Family: none) | 1-10 |
| A | JP 6-151094 A  (Mitsubishi Heavy Industries, Ltd.), 31 May, 1994 (31.05.94), Full text; all drawings (Family: none) | 1-10 |

Form PCT/ISA/210 (continuation of second sheet) (July 1998)